# EUROPEAN PATENT APPLICATION

(11) **EP 4 635 334 A1**
(43) Date of publication of application: **22.10.2025**
(21) Application number: 22968521.9
(22) Date of filing: 16.12.2022
(51) Int. Cl.: A24F 40/51

(54) **FLAVOR INHALER AND FLAVOR INHALATION SYSTEM**

(71) Applicant: Japan Tobacco Inc., Tokyo 105-6927 (JP)
(72) Inventor: ICHINOSE, Atsushi, Tokyo 130-8603 (JP); KOYAMA, Takahiro, Tokyo 130-8603 (JP)
(74) Representative: Hoffmann Eitle
(86) International application number: PCT/JP2022/046308
(87) International publication number: WO 2024/127611

(57) **Abstract**

This flavor inhaler comprises a movable member that has a magnet and is able to move along a first surface, and a substrate on which a Hall sensor is disposed. The magnet is disposed on the movable member such that the direction passing through both poles of the magnet follows the first surface, and the substrate is disposed along a second surface that crosses said direction.

## Description

### TECHNICAL FIELD

The present invention relates to a flavor inhaler and a flavor inhalation system.

### BACKGROUND ART

Flavor inhalers, which heat a material that includes a flavor source to generate an aerosol or the like, without burning the material, are conventionally known. In such a flavor inhaler, a magnet is integrated in a slider that opens and closes an aperture into which a board that includes the aerosol source is inserted, and the position of the slider is detected by a Hall sensor (see PLT 1).

### CITATION LIST

### PATENT LITERATURE

[PTL 1] WO 2022/064560 A1

### SUMMARY OF INVENTION

### TECHNICAL PROBLEM

In cases such as when the flavor inhaler is made compact, the direction of movement of a moveable member such as a sliding cover may intersect with the surface on which a board on which the Hall sensor is arranged extends. In such cases, the magnetic field of the magnet moving with the moveable member may not be detected with a sufficiently high sensitivity.

In view of the above, one object of the present invention is to provide a flavor inhaler and a flavor inhalation system capable of detecting the position of the moveable member with sufficiently high sensitivity, even when the direction of movement of the moveable member moving with the magnet intersects with the surface on which the board on which the Hall sensor is arranged extends.

### SOLUTION TO PROBLEM

According to a first aspect, a flavor inhaler is provided. The flavor inhaler comprises a moveable member having a magnet and that can move along a first surface, and a board on which a Hall sensor is arranged, wherein the magnet is arranged in the moveable member so that a direction through its two poles is along the first surface, and the board is arranged along a second surface that intersects with the direction.

According to the first aspect, a flavor inhaler capable of detecting the position of the moveable member with a sufficiently high sensitivity can be provided, even if the direction of movement of the moveable member moving with the magnet intersects the surface on which the board on which the Hall sensor is arranged extends.

The essential point of a second aspect is that, in the first aspect, the board extends substantially perpendicular to the first surface.

According to the second aspect, a wide board can be arranged in a compact flavor inhaler, such as by arranging the board extending in the longitudinal direction of the flavor inhaler while reducing the distance that the moveable member moves, in a simple configuration.

The essential point of a third aspect is that, in the first or second aspect, the Hall sensor is arranged to detect a magnetic field substantially parallel to the direction.

According to the third aspect, the magnetic field of the magnet of the sliding cover can be detected with an even higher sensitivity.

The essential point of a fourth aspect is that, in the third aspect, the direction of the magnetic field to be detected is configured to be substantially perpendicular to the board.

According to the fourth aspect, the Hall sensor can be arranged on the board in a simpler or more compact configuration.

The essential point of a fifth aspect is that, in any one of the first to fourth aspects, the Hall sensor is configured to not perform bipolar detection.

According to the fifth aspect, the complexity of the output of the Hall sensor is reduced, and the position of the moveable member can be detected more stably.

The essential point of a sixth aspect is that, in any one of the first to fifth aspects, the direction and the second surface intersect between the two poles of the magnet when the moveable member is in a position detected by the Hall sensor.

According to the sixth aspect, the angle between the sensing direction of the Hall sensor and the direction of the magnetic field of the magnet can be reduced, and the magnetic field of the magnet can be detected with a higher sensitivity.

The essential point of a seventh aspect is that, in any of the first to sixth aspects, it further comprises a housing, wherein the moveable member is configured to slide along the housing.

According to the seventh aspect, the flavor inhaler can be made more compact.

The essential point of an eighth aspect is that, in any one of the first to seventh aspects, it further comprises a control unit and a heating part for heating consumable material, wherein the moveable member can move between a first position that does not cover an aperture in which the consumable material is inserted and a second position that covers the aperture, and the control unit is configured to control the heating part based on output from the Hall sensor.

According to the eighth aspect, wasteful heating can be reduced and a more efficient and safer flavor inhaler can be provided.

According to a ninth aspect, a flavor inhalation system is provided. The flavor inhalation system comprises the flavor inhaler according to any of the first to eighth aspects, and consumable material.

According to the ninth aspect, a flavor inhalation system can be provided that is capable of detecting the position of the moveable member with a sufficiently high sensitivity even if the direction of movement of the moveable member moving with the magnet intersects the surface on which the board on which the Hall sensor is arranged extends.

### BRIEF DESCRIPTION OF DRAWINGS

FIG. 1 is a perspective view showing a flavor inhaler according to an embodiment of the present disclosure;
FIG. 2 is an oblique view of a flavor inhaler containing consumable material;
FIG. 3 is a cross-sectional view showing the flavor inhaler along the arrows 3-3 in FIG. 1;
FIG. 4 is a bottom surface view of the flavor inhaler;
FIG. 5 is a perspective view showing the bottom surface of the flavor inhaler;
FIG. 6 is a cross-sectional view schematically showing a vent opening and a covering member;
FIG. 7 is a conceptual view showing a vent opening;
FIG. 8 is a plan view showing the flavor inhaler with the sliding cover in the open position;
FIG. 9 is a plan view showing a flavor inhaler with the sliding cover in the closed position;
FIG. 10 is a conceptual view showing a flavor inhaler connected to an external device;
FIG. 11 is a cross-sectional view of a flavor inhaler showing the sliding cover magnet and Hall sensor;
FIG. 12 is a conceptual view to explain detection of the position of the sliding cover;
FIG. 13 is a conceptual view to explain detection of the position of the sliding cover;
FIG. 14 is a cross-sectional view schematically showing a vent opening and covering member according to variant 1-1;
FIG. 15 is a conceptual view showing the distribution of adhesive according to variant 1-1;
FIG. 16 is a conceptual view illustrating the distribution of the adhesive according to variant 1-2;
FIG. 17 is a conceptual view illustrating the distribution of the adhesive according to variant 1-3;
FIG. 18 is a conceptual view illustrating the distribution of the adhesive according to variant 1-4;
FIG. 19 is a plan view schematically showing the flavor inhaler according to variant 2-1;
FIG. 20 is a plan view schematically showing the flavor inhaler according to variant 2-2; and
FIG. 21 is a cross-sectional view schematically showing the arrangement of the magnet and Hall sensor in a conventional flavor inhaler.

### DESCRIPTION OF EMBODIMENTS

Embodiments of the present disclosure are described below with reference to the drawings. In the drawings described below, the same or equivalent constituent elements are indicated by the same symbols, and will not be described more than once.

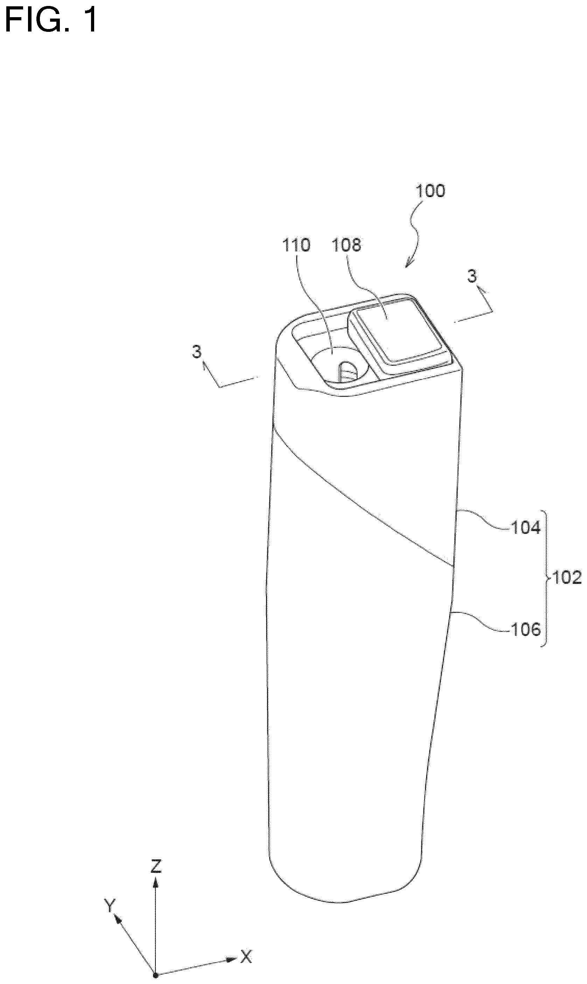

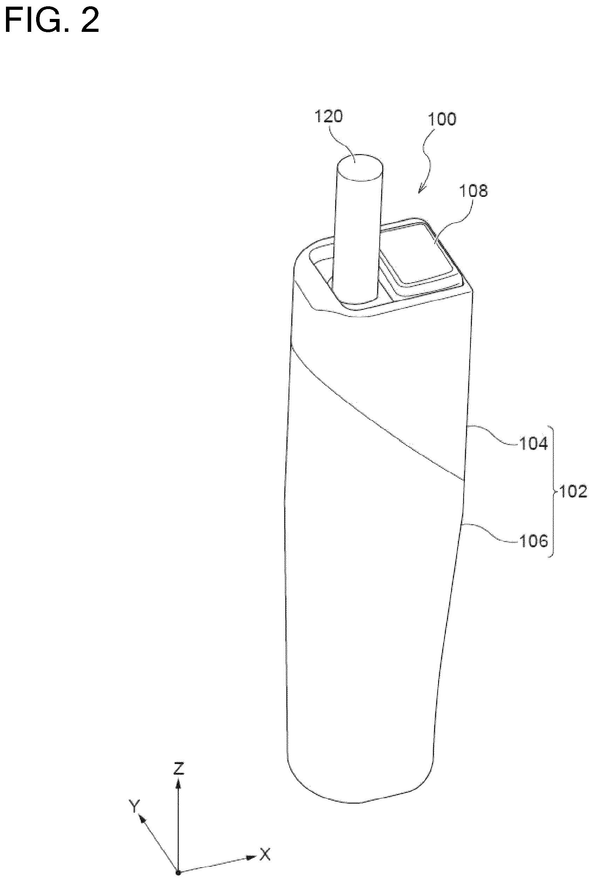

FIG. 1 is an oblique view showing a flavor inhaler 100 according to an embodiment of the present invention. FIG. 2 is an oblique view of the flavor inhaler 100 containing consumable material 120 inserted through an aperture 110. An X-Y-Z orthogonal coordinate system may be applied to the drawings described in the present specification for convenience of description. In this coordinate system, the Z-axis is oriented vertically upwards, the X-Y plane is arranged cutting across the flavor inhaler 100 in a horizontal direction, and the Y-axis is arranged extending from the front surface to the rear surface of the flavor inhaler 100. The Z-axis direction may also refer to the direction of insertion of the consumable material 120 that is accommodated in a chamber 50 to be described later. The X-axis direction can also refer to a device longitudinal direction in a plane perpendicular to the insertion direction of the consumable material 120. The Y-axis direction can also refer to a device lateral direction in a plane perpendicular to the insertion direction of the consumable material 120.

The flavor inhaler 100 according to the present embodiment is, for example, configured to generate an aerosol containing a flavor by heating a stick-type consumable material 120 having a flavor source containing an aerosol source. As an example, the consumable material 120 comprises, on a tip end side in the Z-axis negative direction, a smokable substance that contains a flavor source such as tobacco and an aerosol source, and also comprises a filter on another part. Aerosol base materials that may be cited include glycerol, propylene glycol, triacetin, 1,3-butanediol, and mixtures thereof. It should be noted that, in the present embodiment, the consumable material 120 is described as being stick-shaped, but the consumable material used in the flavor inhaler 100 is not limited to that shape. For example, the consumable material can be configured to include a cartridge accommodating a liquid aerosol source. Furthermore, this cartridge may comprise a heating part.

As shown in FIG. 1, the flavor inhaler 100 comprises a housing 102 formed from an upper housing 104 and a lower housing 106, and a sliding cover 108.

The housing 102 forms the outermost housing of the flavor inhaler 100 and is of a size that fits in the user's hand. When the user is using the flavor inhaler 100, the user can inhale the aerosol while holding the flavor inhaler 100 in their hand. It should be noted that in this housing 102, the upper housing 104 is formed from a resin such as polycarbonate, for example, and the lower housing 106 is formed from a metal such as aluminum, for example. However, the housing 102 is not limited to the materials above and may also be made from a resin, for example, and it is possible to select any suitable material, such as, in particular, polycarbonate (PC), acrylonitrile-butadiene-styrene (ABS) resin, polyether ether ketone (PEEK), or a polymer alloy containing multiple types of polymers.

The upper housing 104 comprises the aperture 110 for receiving the consumable material 120, and the sliding cover 108 is slidably attached to the upper housing 104 so as to close the aperture 110. Specifically, the sliding cover 108 is configured to be movable along an outer surface of the upper housing 104 between a closed position for closing the aperture 110 of the upper housing 104, and an open position (the position shown in FIGS. 1 and 2) for opening the aperture. For example, the user can manually operate the sliding cover 108 to move the sliding cover 108 between the closed position and the open position. As a result, the sliding cover 108 can permit or restrict access of the consumable material 120 to the inside of the flavor inhaler 100.

FIGS. 1 and 2 show the housing 102 of the flavor inhaler 100 in such a way that joint surfaces of the upper housing 104 and the lower housing 106 intersect the X-Y plane at an incline, but the housing 102 is not limited to such a configuration. For example, the housing 102 may also be formed from three or more members.

The flavor inhaler 100 may further include a terminal, which is not shown in the drawings. The terminal may be an interface for connecting the flavor inhaler 100 to an external power source, for example. When the power source of the flavor inhaler 100 is a rechargeable battery, the external power source can be connected to the terminal so that current is supplied from the external power source to the power source, and the power source can be charged. Also, data relating to operation of the flavor inhaler 100 may be sent to an external device by connecting a data transmission cable to the terminal.

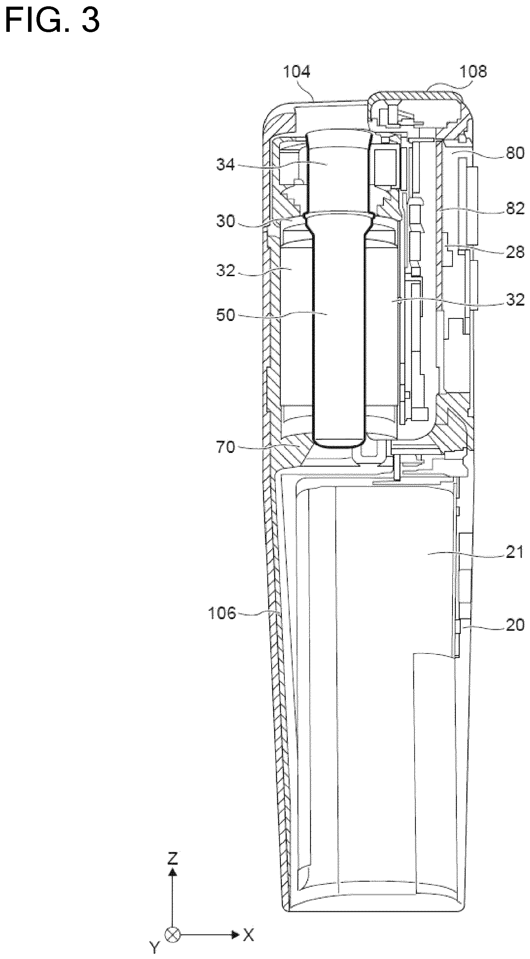

Next, the internal structure of the flavor inhaler 100 is described. FIG. 3 is a cross-sectional view of the flavor inhaler 100 viewed in the direction of the arrows 3-3 shown in FIG. 1.

As shown in FIG. 3, a power source unit 20, an atomization unit 30, and a control unit 80 are provided in an internal space of the housing 102 of the flavor inhaler 100.

The control unit 80 comprises a board 82. The board 82 can, for example, comprise a microprocessor, or the like, and can control the supply of power from the power source unit 20 to the atomization unit 30. This enables the control unit 80 to control heating of the consumable material 120 by the atomization unit 30. Furthermore, the control unit 80 comprises a Bluetooth (registered trademark) interface 28. The control unit 80 can communicate with an external device via the Bluetooth interface 28.

The power source unit 20 comprises a power source 21 that is electrically connected to the board 82 of the control unit 80. The power source 21 may be a rechargeable battery or a non-rechargeable battery, for example. The power source 21 is electrically connected to the atomization unit 30 via the board 82. In this way the power source 21 can supply power to the atomization unit 30 to heat the consumable material 120 appropriately.

The atomization unit 30 comprises: a chamber 50 extending in the longitudinal direction of the consumable material 120; a heating part 40 (not shown in FIG. 3) surrounding part of the chamber 50; a heat insulation part 32; and a substantially cylindrical insertion guide member 34. The chamber 50 is configured to accommodate the consumable material 120. The heating part 40 is configured to contact an outer circumferential surface of the chamber 50 to heat the consumable material 120 accommodated in the chamber 50. It is also possible, as an example, to provide a susceptor inside or in proximity of the consumable material 120 and to configure the heating part 40 to comprise an induction coil for inductively heating the susceptor.

The heat insulation part 32 is arranged so as to cover the chamber 50 and the heating part 40. The heat insulation part 32 may be an aerogel, for example. The insertion guide member 34 is formed from a resin material such as PEEK, PC or ABS, for example, and is provided between the sliding cover 108 in the closed position and the chamber 50. The insertion guide member 34 communicates with the outside of the flavor inhaler 100 when the sliding cover 108 is in the open position, and guides the insertion of the consumable material 120 into the chamber 50 when the consumable material 120 is inserted into the insertion guide member 34.

Furthermore, the atomization unit 30 and the control unit 80 are covered by a heat diffusion sleeve 70 and arranged in an interior space of the housing 102. The heat diffusion sleeve 70 is made from a material with a high thermal conductivity, such as a metal, to diffuse heat generated in the atomization unit 30 within the housing 102. The heat diffusion sleeve 70 can be configured to not interfere with the lower housing 106 and to be arranged inside only the upper housing 104. Also, the heat diffusion sleeve 70 can be provided with an open region so as not to interfere with communication with an external device by the Bluetooth interface 28 of the control unit 80. Although the metal member generally interferes with electromagnetic waves, the control unit 80 can carry out communication with an external device via the Bluetooth interface 28 through at least the open region of the heat diffusion sleeve 70 as a path.

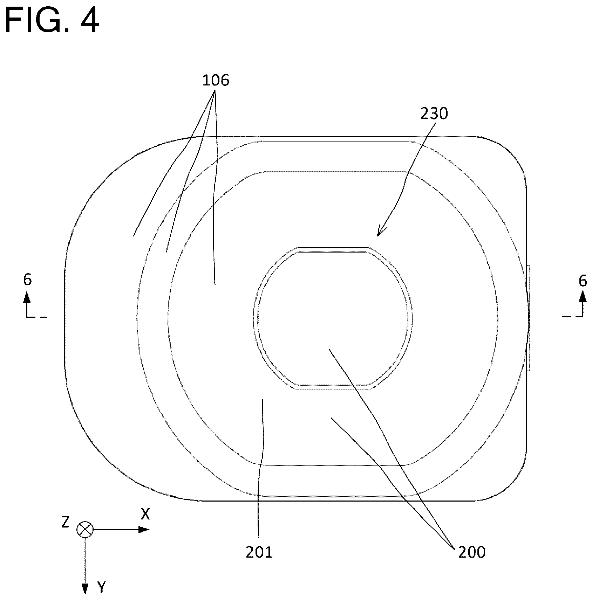

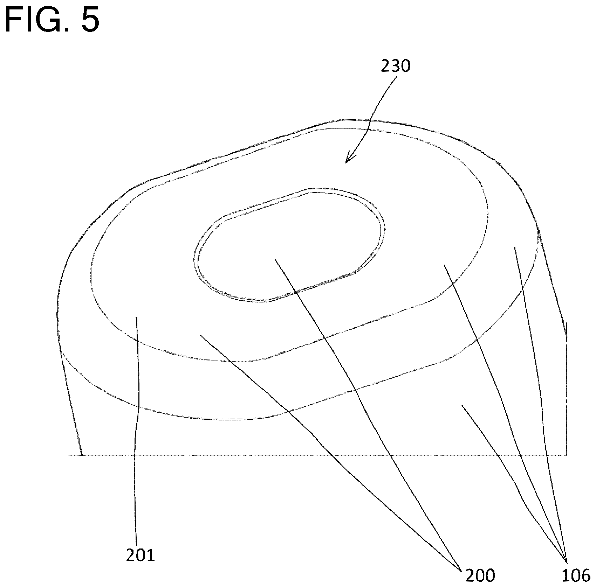

FIG. 4 shows the bottom surface of the flavor inhaler 100. FIG. 5 is an oblique view that includes the bottom surface 200 of the flavor inhaler 100. The flavor inhaler 100 has a first recess 230 formed in the bottom surface 200. The first recess 230 is formed surrounded by a housing bottom surface 201, which is the bottom surface of the housing 102 including the lower housing 106.

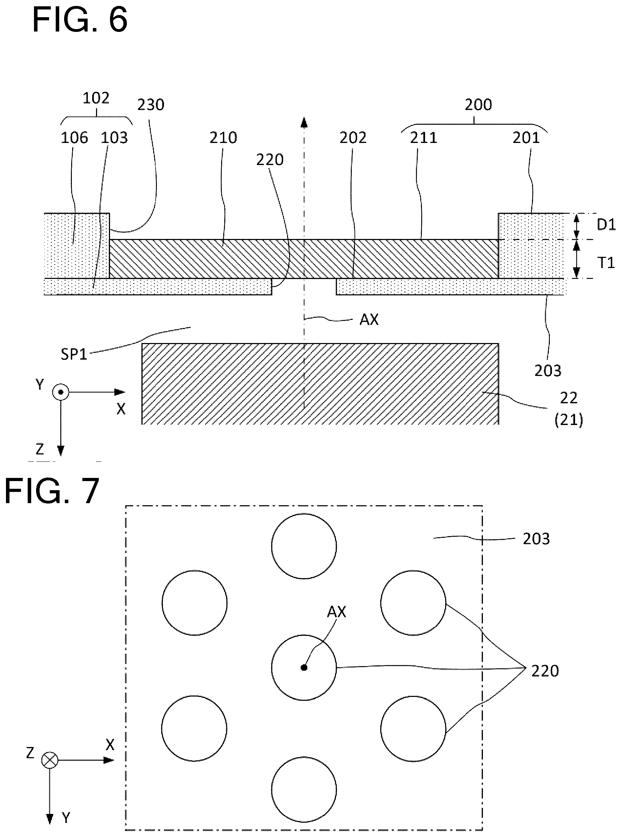

FIG. 6 is a cross-sectional view schematically illustrating the first recess 230. The flavor inhaler 100 comprises a covering member 210. The housing 102 comprises an inner housing 103. The inner housing 103 is located on the inside of the lower housing 106. A vent opening 220 is formed in the inner housing 103, and the covering member 210 is arranged to cover at least a portion of the vent opening 220. The covering member 210 defines the first recess 230. An outer surface 211, which is the outer surface of the covering member 210, constitutes the bottom surface of the first recess 230. The side surfaces of the first recess 230 are configured by the lower housing 106.

In the present embodiment, the power source 21 comprises a battery 22. The battery 22 is arranged in a space SP1 formed inside the housing 102. The battery 22 may be either rechargeable or not. The battery 22 is, for example, a lithium-ion battery. The vent opening 220 is connected to the space SP1 in which the battery 22 is arranged. In the present embodiment, the vent opening 220 opens towards the bottom surface 200 of the flavor inhaler 100, but the position of the vent opening 220 is not particularly restricted provided it is in communication with the space SP1.

The covering member 210 is bonded to an adhesive surface 202, which is an outer surface of the inner housing 103. The covering member 210 and the adhesive surface 202 are configured to be capable of being separated from each other. In other words, the covering member 210 can be peeled from the adhesive surface 202 with a force that does not damage the covering member 210 or the inner housing 103. Preferably, the covering member 210 is arranged covering the whole vent opening 220. In this case, the covering member 210 may be configured to be capable of separating from the adhesive surface 202 based on the pressure of the space SP1. For example, the covering member 210 is configured so that when the pressure inside the flavor inhaler 100 exceeds a threshold pressure that does not adversely affect the equipment inside the flavor inhaler 100, a gap is created between the covering member 210 and the adhesive surface 202 and gas is released from the space SP1. Note that there may be a gap between the outer circumferential surface of the covering member 210 and the inner circumferential surface of the lower housing 106. This enables smooth release of gas when a flow path is formed between the covering member 210 and the adhesive surface 202. This gap is preferably narrow in order to prevent the accumulation of water, dust, etc. in the first recess 230. In this way, at least a portion of the outer circumferential surface of the covering member 210 is preferably separated slightly from the inner circumferential surface of the lower housing 106. In other words the covering member 210 is preferably slightly smaller than the first recess 230 along the adhesive surface 202.

There is no particular limitation on the shape of the covering member 210, provided it can cover at least a portion of the vent opening 220. Preferably, the covering member 210 is sheet-like or seal-like in order to increase the area of adhesion and for compactness. There is no particular limitation on the material of the covering member 210, and it can be paper or a synthetic resin such as polycarbonate (PC), polyethylene terephthalate, or polyvinyl chloride. Preferably, the covering member 210 comprises a water-resistant synthetic resin in order to prevent water ingress inside the flavor inhaler 100.

There is a possibility that members bonded to the housing 102 or the like may be peeled off by a user or become loose or misaligned due to contact with external members. In the flavor inhaler 100 of the present embodiment, the covering member 210 covering the vent opening 220 is arranged in the first recess 230, whereby contact with a user's finger or an external member becomes difficult, making it possible to reduce these issues. It is also possible to prevent the adhesive from leaking onto the surface of the housing 102. Furthermore, the depth D1 of the first recess 230 is smaller than the thickness T1 of the covering member 210. If the depth D1 is too large, the smoothness of the outer surface of the flavor inhaler 100 is lost, and there is an increased risk of foreign matter such as water and dust being deposited in the first recess 230. If the thickness T1 is too small, the covering member 210 is prone to tearing due to contact with a needle or the like. Having a depth D1 smaller than a thickness T1 allows the flavor inhaler 100 to be compact while taking these into consideration. In addition, the depth D1 of the first recess 230 is smaller than the thickness T1 of the covering member 210, which facilitates recognition of defective products because the covering member 210 will protrude from the housing bottom surface 201 if multiple covering members 210 are incorrectly placed on top of each other during the manufacture of the flavor inhaler 100. As a non-limiting example, the thickness T1 of the covering member 210 can be 0.2 mm or more and 0.4 mm or less, and the depth D1 of the first recess 230 can be 0.2 mm or less.

FIG. 7 is a conceptual view showing the vent openings 220 on an inner surface 203, which is the inner surface of the inner housing 103. In the illustrated example, the vent openings 220 are defined by a cylindrical side wall around their central axis AX. Also, a plurality of vent openings 220 is formed on the inner surface 203, with each vent opening 220 arranged at a position corresponding to the center and each apex of a hexagon. However, there is no particular limitation on the shape, number and position of the vent openings 220. Note that in the illustrated example, the lower housing 106 and the inner housing 103 are separate members, but they may be integrally formed.

The flavor inhaler 100 and the consumable material 120 constitute a flavor inhalation system. The flavor inhaler 100 and the flavor inhalation system of the present embodiment comprise the housing 102 having the vent opening 220; the battery 22 arranged inside the housing 102 in the space SP1 in communication with the vent opening 220; and the covering member 210 covering at least part of the vent opening 220. The covering member 210 is bonded to the housing 102 so that it can be separated from the housing 102. The covering member 210 constitutes the bottom surface of the first recess 230 formed in the housing bottom surface 201, which is an outer surface of the housing 102. The depth D1 of the first recess 230 is less than the thickness T1 of the covering member 210. In this way it is possible to provide a compact configurable flavor inhaler 100 and flavor inhaler system with a vent opening 220 more stably covered by the covering member 210, which is less prone to misalignment or detachment.

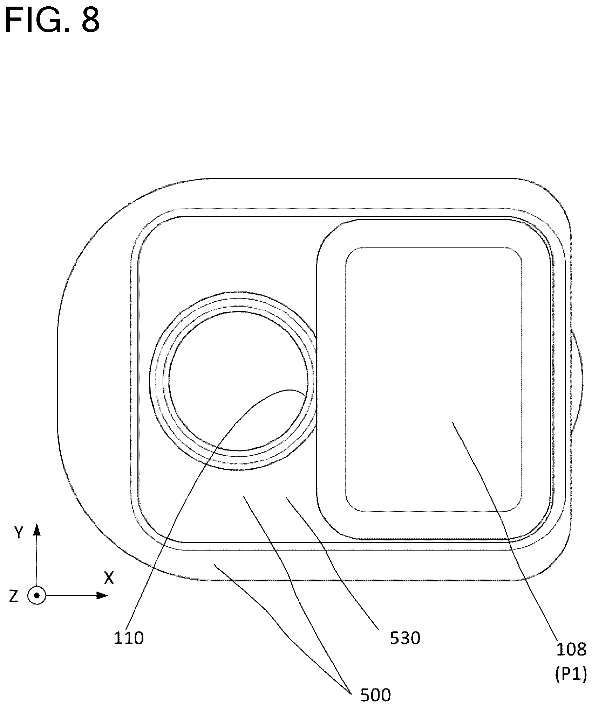

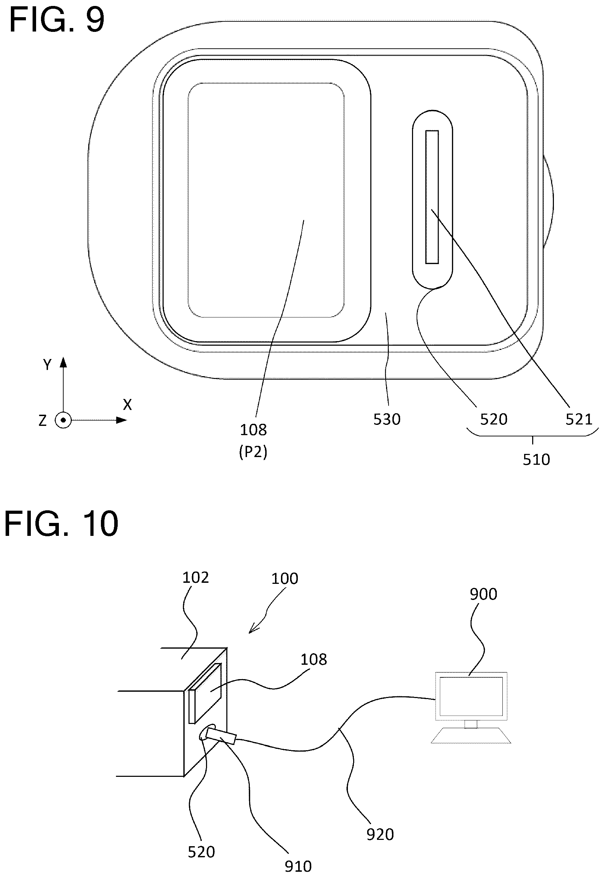

FIG. 8 is a plan view showing the flavor inhaler 100 when the sliding cover 108 is in a first position P1. FIG. 9 is a plan view showing the flavor inhaler 100 when the sliding cover 108 is in a second position P2. The flavor inhaler 100 has a second recess 530 formed in an upper surface 500 thereof. The flavor inhaler 100 comprises an interface portion 510. The interface portion 510 comprises an aperture 520 formed in the upper surface 500, and a connection portion 521. In the following, the above-mentioned aperture 110 in which the consumable material 120 is inserted is referred to as the first aperture 110 and the aperture 520 as the second aperture 520. In the illustrated example, the first aperture 110 and the interface portion 510 are formed in the second recess 530, but the first aperture 110 and the interface portion 510 need not be formed in the recess.

The interface portion 510 mediates the exchange of information, data, electrical power, and so on, between the control unit 80 or the power source unit 20 and the exterior of the flavor inhaler 100. In the present embodiment, the connection portion 521 comprises a connection terminal for connecting an external device. A terminal of an external device is inserted into the second aperture 520 and is electrically connected to a connection terminal of the connection portion 521. In the illustrated example, the connection terminal of the connection portion 521 has a plate-like shape protruding inside the second aperture 520, but the shape of the connection portion 521 is not particularly limited provided an electrical connection is possible.

The first position P1 is a position in which the sliding cover 108 covers at least a part of the interface portion 510. In the first position P1, the sliding cover 108 obstructs the connection from an external device to the connection portion 521. Preferably, the first position P1 is an open position in which insertion of the consumable material 120 into the first aperture 110 is possible, as in the illustrated example.

The second position P2 is a position where at least a portion of the first aperture 110 is covered. In the second position P2, the sliding cover 108 obstructs insertion of the consumable material 120 into the first aperture 110. In the second position P2, it is preferable for a connection from an external device to the connection portion 521 to be possible, as in the illustrated example.

The sliding cover 108 is a moveable member configured to be capable of moving between the first position P1 and the second position P2. In the present embodiment, the sliding cover 108 is moved by sliding, but movement of the moveable member between the first position P1 and the second position P2 may be by pivoting or the like. In order to configure a compact flavor inhaler 100, it is preferable for the moveable member to be capable of sliding between the first position P1 and the second position P2.

It is preferable that the first aperture 110 and the interface portion 510 are formed on the upper surface 500, which is one end face of the longitudinally extending housing 102. This reduces the distance travelled by the sliding cover 108 and allows the flavor inhaler 100 to be configured simply or compactly.

In the present embodiment, the sliding cover 108 is configured to be capable of moving between the first position P1 covering at least a portion of the interface portion 510 and in particular the second aperture 520, and the second position P2 covering at least a portion of the first aperture 110. This can make the connection between the connection portion 521 and an external device difficult when the consumable material 120 is inserted into the first aperture 110. Therefore, adverse effects on the interface portion 510 of foreign matter, such as secondhand smoke from heating of the consumable 120 or smoke exhaled by the user, can be reduced. It can also be difficult for the user to insert the consumable material 120 into the first aperture 110 when the interface portion 510 is in use, such as when a terminal of an external device is connected to the connection portion 521. Therefore, when the interface portion 510 is in use, heating of the consumable material 120 can be prevented and the generation of foreign matter such as secondhand smoke can be reduced. In this way, in the present embodiment, the negative impact of foreign matter on the interface portion 510 can be reduced by making it difficult to insert the consumable material 120 and use the interface portion 510 at the same time.

It is preferable that the sliding cover 108 does not cover the first aperture 110 in the first position P1. This can prevent the connection portion 521 from being connected with an external device when the consumable material 120 is inserted into the first aperture 110. The adverse effect of foreign matter such as secondhand smoke on the interface portion 510 can therefore be further reduced.

It is preferable that the sliding cover 108 does not cover the interface portion 510, in particular the second aperture 520, in the second position P2. This can prevent insertion of the consumable material 120 into the first aperture 110 by the user when the interface portion 510 is in use. For example, the connection between the connection portion 521 and an external device can only be enabled when the first aperture 110 is covered by the sliding cover 108. With such an arrangement, when the interface portion 510 is in use, the consumable material 120 is not heated, reducing the generation of foreign matter such as secondhand smoke and reducing the adverse effect of foreign matter on the interface portion 510.

In view of the foregoing, it is more preferable that the sliding cover 108 is configured to be capable of moving between the first position P1 in which it covers at least a portion of the interface portion 510 and does not cover the first aperture 110, and the second position P2 in which it covers at least a portion of the first aperture 110 and does not cover the interface portion 510.

FIG. 10 is a conceptual view illustrating the connection of the flavor inhaler 100 and an external device 900. The connection portion 521 is electrically connected to the external device 900 via an external terminal 910 and a conductor 920. At least one of a computer, a power source, an input device and a display device can be configured to be connected as the external device 900. This can enable changing the setting or charging of the flavor inhaler 100, or display of information about the flavor inhaler 100, etc. From the same perspective, the connection portion 521 is preferably electrically connected to at least one of the control unit 80 and the power supply unit 20 inside the flavor inhaler 100.

Preferably, the connection portion 521 comprises a USB port capable of communication according to the Universal Serial Bus (USB) standard. This enables various functions such as data input/output and charging, and makes use of the convenience of USB connections, such as plug and play.

As shown in FIGS. 8 and 9, the shapes of the first aperture 110 and the second aperture 520 are preferably different. This can reduce the risk of inserting the consumable material 120 into the second aperture 520 by mistake or inserting the external terminal 910 into the first aperture 110. This can prevent scratches, and foreign matter from entering the inside of the flavor inhaler 100.

The flavor inhaler 100 preferably comprises a detector that detects whether the sliding cover 108 is in the first position P1 or the second position P2. In the following, detection of the sliding cover 108 comprising a magnet by a detector comprising a Hall sensor is described.

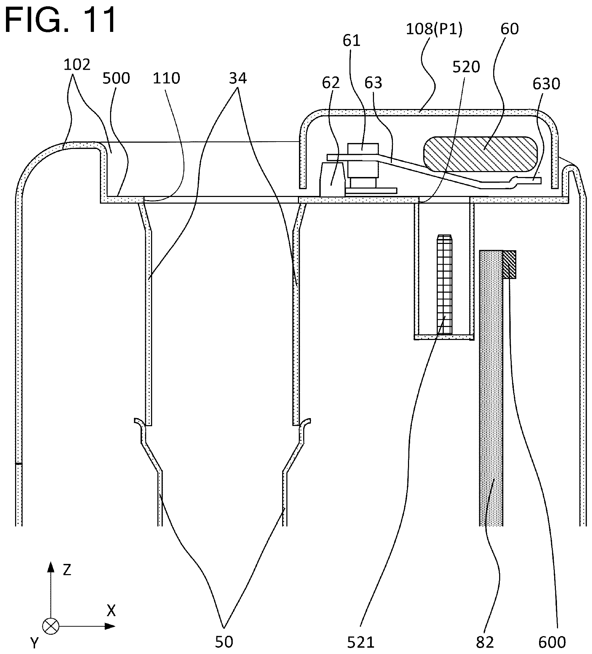

FIG. 11 is a cross-sectional view schematically showing the Hall sensor 600, and the magnet 60 arranged in the sliding cover 108. FIG. 11 corresponds to an enlarged view of the cross-section 3-3 in FIG. 1 at the top of the flavor inhaler 100, and illustration of some parts has been omitted as appropriate depending on the relevance to the following description. FIG. 11 shows the sliding cover 108 in the first position P1 covering the second aperture 520 on the upper surface 500 side of the connection portion 521.

The magnet 60 is arranged inside the sliding cover 108. In the illustrated example, the magnet 60 is supported by a support member that is not illustrated, and is configured to move integrally with the sliding cover 108. There is no particular limitation regarding the size of the magnet 60 and its relative position in the sliding cover 108 provided it moves as the sliding cover 108 moves. There is no particular limitation regarding the type of magnet, but a permanent magnet is preferred as no wiring is required.

As long as the sliding cover 108 is capable of moving between the first position P1 and the second position P2, there is no particular limitation regarding its embodiment. In the illustrated example, a first protrusion 61 extending in the Z-axis direction is fixed to the upper surface 500 of the housing 102, an elongated hole extending in the X-axis direction is formed in a plate-like member (not shown on the drawings) that is fixed to the sliding cover 108 and extends along the XY plane, and the inner wall of the elongated hole slides along the first protrusion 61. The first aperture 110 and the second aperture 520 are formed in the center of the upper surface 500 in the Y-axis direction, and for stability, the first protrusion 61 and the elongated hole are formed on both sides, to the outside in the Y-axis direction of the first aperture 110 and the second aperture 520. However, a guide member may be provided on the upper surface 500 of the housing 102 and the sliding cover 108 may slide along the guide member. The plate-like member is preferably made of metal for increased strength.

Also, in the illustrated example, a biasing member 63 is arranged in the sliding cover 108. The biasing member 63 comprises an elastic member made from metal or the like that extends plate-like in the X-axis direction, with an engagement part 630 formed at an end thereof. When the sliding cover 108 is moved to the second position P2, a second protrusion 62 fixed to the upper surface 500 is engaged on the negative Z-axis side of the engagement portion 630. The engagement portion 630 is provided with a step or the like, to make the second protrusion 62 difficult to move when engaged with the second protrusion 62. The assembly may be configured so that there is an audible click when the second protrusion 62 engages with the step of the engagement portion 630. The biasing member 63 is configured to bias the second protrusion 62 so that the engagement portion 630 does not disengage from the second protrusion 62 with a slight force, but disengages when the user slides the sliding cover 108 by hand. This allows the sliding cover 108 to be more stably held in the second position P2. The flavor inhaler 100 may comprise another set of second protrusion 62 and biasing member 63 so that the sliding cover 108 can be held stably in this way when it is in the first position P1. Note that the second protrusion 62 and the biasing member 63 need not be provided in the flavor inhaler 100.

The Hall sensor 600 is arranged in a position in which the magnet 60 in the first position P1 or the second position P2 can be detected. There is no particular limitation regarding the position of the Hall sensor 600, provided it is able to detect a magnetic field of different magnitude when the magnet 60 is in the first position P1 and the second position P2, or if it is able to detect a magnetic field at only one of the positions. In the illustrated example, the distance between the Hall sensor 600 and the first position P1 is less than the distance between the Hall sensor 600 and the second position P2. Therefore, it is possible to render the assembly so that the Hall sensor 600 can detect the magnet 60 of the sliding cover 108 in the first position P1, and cannot detect the magnet 60 of the sliding cover 108 in the second position P2 from the Hall sensor 600. The Hall sensor 600 is electrically connected to the control unit 80. In view of a more simple configuration, the Hall sensor 600 is preferably arranged on the board 82, as in the illustrated example. Also the Hall sensor 600 is preferably arranged at the end of the board 82 on the upper surface 500 side, from the perspective of detecting the magnetic field of the magnet 60 with high sensitivity.

In the present embodiment, the sliding cover 108 is configured to move along the upper surface 500 extending substantially parallel to the XY plane, and the board 82 is arranged along a YZ plane intersecting the upper surface 500. This arrangement allows the board 82 to extend in the longitudinal direction of the flavor inhaler 100 and to arrange a wide board 82 in the compact flavor inhaler 100 while reducing the distance travelled by the sliding cover 108 and keeping the configuration simple.

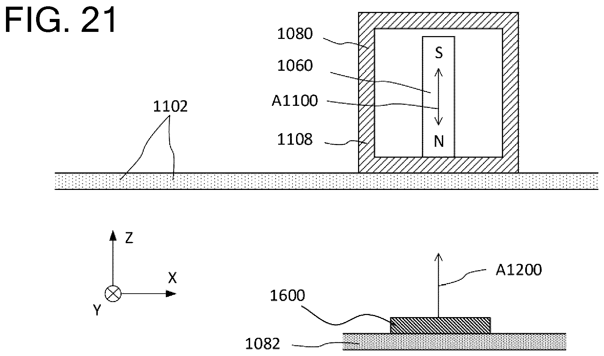

FIG. 21 is a conceptual view to illustrate detection of a magnet 1060 in a sliding cover 1080 in a conventional flavor inhaler. In the following, the direction through both poles of the magnet is referred to as the magnet direction, and the direction of the magnetic field detected by the Hall sensor is referred to as the sensing direction. In a conventional flavor inhaler, a housing 1102 and a board 1082 are arranged in parallel, and the magnet direction (arrow A1100) through the poles of the magnet 1060 is arranged perpendicular to the housing 1102. In this case, the sensing direction of the magnetic field at the Hall sensor 1600 (arrow A1200) and the magnet direction can be in line, enabling efficient detection by the Hall sensor 1600. On the other hand, in the present embodiment, it is not easy to arrange the magnetic field sensing direction and the magnet direction in the same line because the Hall sensor 600 is arranged on the board 82 extending along a surface that intersects the upper surface 500 of the housing 102, as shown in FIG. 11.

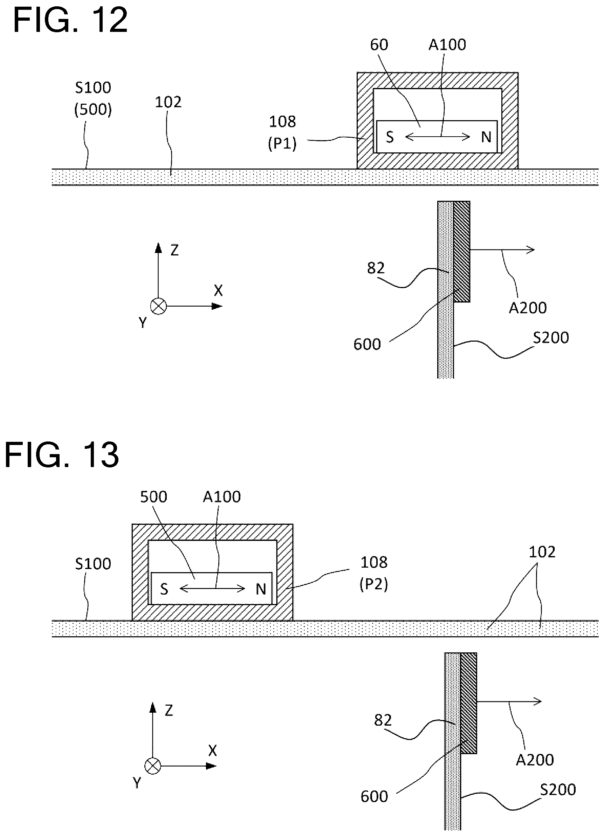

FIG. 12 is a cross-sectional view schematically illustrating the configuration of the magnet 60 and the Hall sensor 600 in the first position P1 in the present embodiment. FIG. 13 is a cross-sectional view schematically illustrating the configuration of the magnet 60 and the Hall sensor 600 in the second position P2 in the present embodiment.

The sliding cover 108 is configured to be moveable along a first surface S100, which corresponds to the upper surface 500 of the housing 102. The magnet 60 is arranged in the sliding cover 108 so that the magnet direction through the N and S poles of the magnet 60 is along the first surface S100. In FIG. 12, the magnet direction is shown schematically by arrowA100. The angle between the first surface S100 and the magnet direction is preferably no more than 30 degrees, more preferably no more than 15 degrees. A small angle between the first surface S100 and the magnet direction makes it easier to arrange a longer magnet 60. The longer the magnet 60, the stronger the magnetic force, further facilitating the detection of the magnetic field by the Hall sensor 600.

The board 82 is arranged to intersect the magnet direction. In other words, the board 82 is arranged along a second surface S200, which is a surface that intersects the magnet direction. The angle between the magnet direction and the second surface S200 is preferably greater than or equal to 60 degrees and less than or equal to 120 degrees, more preferably greater than or equal to 75 degrees and less than or equal to 105 degrees, and still more preferably the magnet direction and the second surface S200 are substantially perpendicular. The closer this angle is to the perpendicular, the easier it is to configure a smaller angle between the sensing direction and the direction of the magnetic field of the magnet 60 at the Hall sensor 600, and the easier it is to detect the magnetic field.

The Hall sensor 600 comprises a Hall element and processing circuitry to process the output of the Hall element. The processing circuitry comprises, for example, an operational amplifier for amplifying the output of the Hall element. In order to make it easier to detect the magnetic field of the magnet 60, the Hall sensor 600 and its Hall element are arranged to detect a magnetic field substantially parallel to the magnet direction. It is preferable for the Hall sensor 600 to be arranged on the board 82 so that the sensing direction of the Hall sensor 600 is substantially perpendicular to the board 82. This allows the Hall sensor 600 to be arranged on the board 82 in a simpler or more compact configuration.

There is no particular limitation regarding the type and sensing method of the Hall sensor 600 provided that the magnetic field of the magnet 60 can be detected. However, the Hall sensor 600 is preferably not configured to perform bipolar detection. In the present embodiment, as both poles of the magnet 60 can approach the Hall sensor 600, the detected magnetic field varies in a complex manner, and if both poles are detected, a complex process may be required to determine the position of the sliding cover 108. This possibility can be reduced by the Hall sensor 600 being configured to only perform unipolar detection, for example.

The angle between the first and second surfaces S100, S200 is preferably greater than or equal to 60 degrees and less than or equal to 120 degrees, and more preferably greater than or equal to 75 degrees and less than or equal to 105 degrees. The board 82 preferably extends substantially perpendicular to the first surface S100. This allows the board 82 to extend in a direction perpendicular to the direction of movement, even if the distance travelled by the sliding cover 108 is short, and a large area of board 82 can be installed.

The magnet direction and the second surface S200 preferably intersect between the two poles of the magnet 60 in a state where the sliding cover 108 is in the first position P1 or the second position P2, which are the sensed positions. More specifically, in FIG. 12, the position of the board 82 in the X-axis direction is preferably between the positions of the poles of the magnet 60 in the X-axis direction. This allows the angle between the sensing direction and the direction of the magnetic field of the magnet 60 at the first position P1 or the second position P2 to be reduced, allowing more sensitive detection of the magnetic field of the magnet 60.

The control unit 80 controls the flavor inhaler 100 based on the output from the Hall sensor 600. The control unit 80 preferably controls heating by the heating part 40 based on the output from the Hall sensor 600. For example, an ON signal detecting a magnetic field or an OFF signal not detecting a magnetic field is output from the Hall sensor 600 to the control unit 80. When the control unit 80 receives the ON signal, there is a sliding cover 108 in the first position P1 and the first aperture 110 is in an open state, so heating can be allowed. When the control unit 80 receives the OFF signal, heating can be prevented because there is no sliding cover 108 in the first position P1 and the first aperture 110 is in the closed state. With this arrangement, wasteful heating can be prevented and a more efficient and safer flavor inhaler can be provided.

The flavor inhaler 100 and the flavor inhalation system of the present embodiment comprise the sliding cover 108 having the magnet 60 that can move along the first surface S100, and the board 82 comprising the Hall sensor 600, wherein the magnet 60 is arranged in the sliding cover 108 so that the direction through its two poles is along the first surface S100, and the board 82 is arranged along the second surface S200 that intersects with that direction. As a result, the flavor inhaler 100 and the flavor inhalation system capable of detecting the position of the sliding cover 108 with sufficiently high sensitivity even when the direction of movement of the sliding cover 108 moving with the magnet 60 intersects the surface on which the board 82 on which the Hall sensor 600 is arranged extends can be provided.

### Variant 1-1

In the embodiment described above, the amount or the properties of the adhesive that bonds the covering member 210 and the inner housing 103 at the adhesive surface 202 may be uneven depending on the position on the adhesive surface 202. For clarity, the following example is described for the case where the number of vent openings 220 is one.

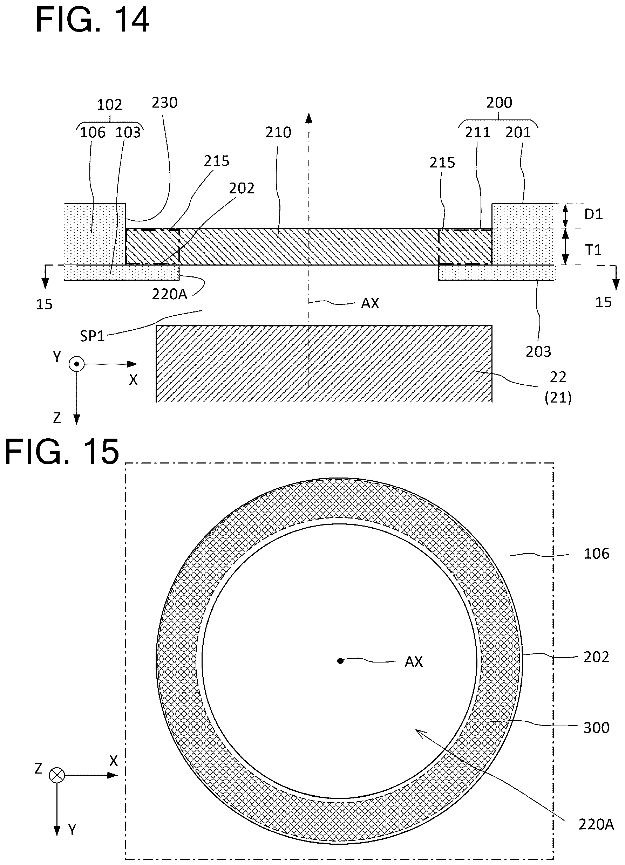

FIG. 14 is a cross-sectional view schematically illustrating a vent opening 220A and the covering member 210 according to the present variant. FIG. 15 is a conceptual view showing the vent opening 220A and an adhesive layer 300, showing a cross section 15-15 perpendicular to the central axis AX (FIG. 14). The hatching of the lower housing 106 is omitted. In the illustrated example, the vent opening 220A is formed with rotational symmetry about the central axis AX and is a circular through-hole when viewed from the bottom surface 200 side.

As shown in FIG. 14, the covering member 210 has a peripheral portion 215 facing the inner housing 103 along the central axis AX. In the present variant, the peripheral portion 215 is a strip formed surrounding the vent opening 220A, but there is no particular limitation on the shape of the peripheral portion 215. Hereinafter, "strip-shaped" includes the case where the covering member 210 is formed along a closed curve so that it is circular. Including cases where the flavor inhaler 100 has multiple vent openings 220 formed therein as in the embodiment described above, the peripheral portion of the covering member 210 that faces the wall portion in which the vent opening 220 is formed along the central axis AX is referred to as the peripheral portion 215. The peripheral portion 215 faces the adhesive surface 202 of the inner housing 103. The peripheral portion 215 is arranged surrounding the one or a plurality of vent openings 220.

As shown in FIG. 15, the adhesive layer 300, which is a layer of adhesive, is formed between the peripheral portion 215 of the covering member 210 and the adhesive surface 202 of the inner housing 103. There is no particular limitation regarding the type of adhesive in the adhesive layer 300, and it can be, for example, a resin or the like. The amount or the properties of the adhesive layer 300 on the adhesive surface 202 are preferably uneven. As a result, a part that can be easily peeled is provided on the covering member 210, making it easier to peel the covering member 210 when the interior of the flavor inhaler 100 is at the desired pressure. There is no particular limitation regarding the properties of the adhesive that differ depending on the position on the adhesive surface 202, provided that they affect the ease with which the covering member 210 can be peeled off, and may be, for example, the adhesive strength.

### Variant 1-2

In variant 1-1 as described above, on a portion of the peripheral portion 215, the width of the adhesive layer 300 that contacts the peripheral portion 215 may be different from the width of the adhesive layer 300 that contacts the other parts of the peripheral portion 215.

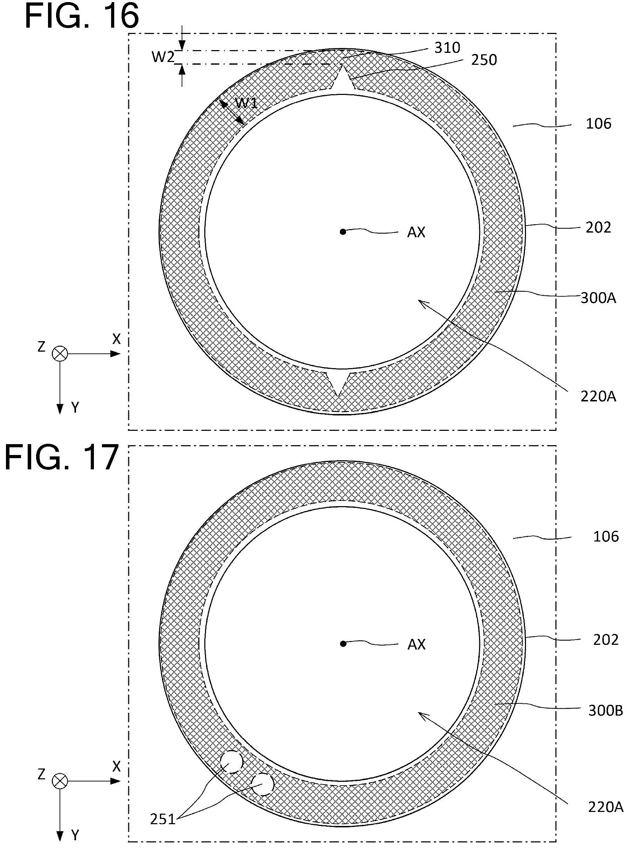

FIG. 16 is a conceptual view showing an adhesive layer 300A according to the present variant. The adhesive layer 300A is formed in a strip-like shape having a first width W1. However, at two circumferential locations about the central axis AX, a gap 250 between the covering member 210 and the adhesive surface 202 protrudes into the adhesive layer 300A, and the portion of the adhesive layer 300A facing the gap 250 constitutes a weak area 310 having a second width W2 that is smaller than the first width W1. In the illustrated example, the adhesive layer 300A has two weak areas 310, but there is no particular limitation regarding the number and location of the weak areas 310.

In the flavor inhaler 100 of the present variant, the adhesive is arranged in a strip, wherein at a portion of the peripheral portion 215 the width of the adhesive is smaller than the width of the other parts of the peripheral portion 215. This can make it easier for the covering member 210 to peel off more reliably when the interior of the flavor inhaler 100 is at the desired pressure.

### Variant 1-3

In variant 1-1, the flavor inhaler 100 may further comprise an adhesive-free region between the peripheral portion 215 and the adhesive surface 202 of the housing 102, that is surrounded by adhesive.

FIG. 17 is a conceptual view showing an adhesive layer 300B according to the present variant. The flavor inhaler 100 comprises a first region 251 surrounded by the adhesive layer 300B in a plane perpendicular to the central axis AX. The first region 251 is a region where no adhesive is provided. The first region 251 is preferably an air layer. In this case also, the covering member 210 can be more reliably peeled off when the interior of the flavor inhaler 100 is at the desired pressure.

### Variant 1-4

In variant 1-1, an airflow path may be formed in communication with the interior and exterior of the flavor inhaler 100 between adhesive layers 300.

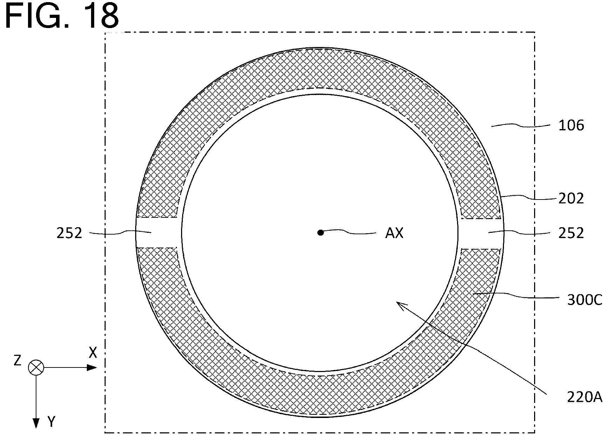

FIG. 18 is a conceptual view showing an adhesive layer 300C according to the present variant. The flavor inhaler 100 comprises a second region 252. The second region 252 is region where no adhesive is provided that extends radially in between the covering member 210 and the adhesive surface 202. The second region 252 is an air flow path in communication with the interior and exterior of the flavor inhaler 100. In the illustrated example, because the adhesive layer 300C is annular, the second region 252 extends radially from the inside to the outside of the adhesive layer 300C. In this way, the flavor inhaler 100 further comprises the adhesive-free second region 252 extending along the surface (XY plane) on which the covering member 210 extends from the vent opening 220A side of the peripheral portion 215 to the opposite side. As a result, it is possible to restrict the rise of pressure on the inside of the flavor inhaler 100.

### Variant 1-5

In the embodiments described above, the adhesive of the adhesive layer 300 may be configured to be easily peeled off due to heat when gas is generated from the battery 22. For example, an adhesive can be used so that the adhesive strength decreases at temperatures higher than the normal temperature range occurring during flavor inhalation. This can make it easier for the covering member 210 to be peeled off more reliably when the interior of the flavor inhaler 100 is at the desired pressure.

### Variant 2-1

In the embodiments described above, an input portion such as a button or the like may be arranged on the upper surface 500 in addition to or as an alternative to the second aperture 520.

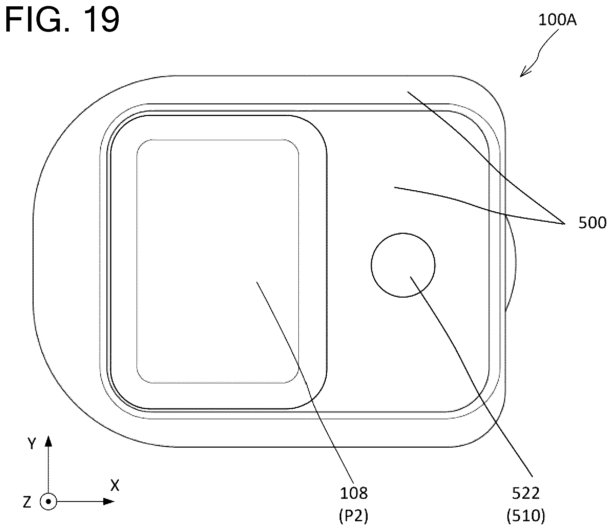

FIG. 19 is a plan view schematically illustrating a flavor inhaler 100A according to the present variant. The flavor inhaler 100A has a substantially similar configuration to the flavor inhaler 100 described above, but differs from the flavor inhaler 100 in that, as the interface portion 510, an input portion 522 is provided instead of the second aperture 520.

The input portion 522 comprises an input device. In the illustrated example, the input portion 522 is a button. However, the input portion 522 is not limited thereto and can comprise any input device that can be arranged on the upper surface 500. For example, the input portion 522 can comprise a touch panel or a switch, and so on. The input portion 522 may act as an operation portion for a user to operate parts of the flavor inhaler 100A.

The flavor inhaler 100A is configured so that when the sliding cover 108 is in the first position P1, at least a portion of the input portion 522 is covered by the sliding cover 108 and the input portion 522 cannot be operated by the user. As shown in FIG. 19, the flavor inhaler 100A is configured so that when the sliding cover 108 is in the second position P2, at least a portion of the first aperture 110 is covered and consumable material 120 cannot be inserted into the first aperture 110. When the sliding cover 108 is in the second position P2, the input portion 522 may be operated by the user.

Such an arrangement can make it difficult for the input portion 522 to be operated by the user when consumable material 120 is inserted into the first aperture 110. Also, when the input portion 522 is in use, insertion of the consumable material 120 into the first aperture 110 by the user can be made difficult. Thus, the generation of foreign matter such as secondhand smoke or user-exhaled smoke and contact of the foreign matter with the input portion 522 can be reduced, and adverse effects of the foreign matter on the input portion 522 can be reduced.

### Variant 2-2

In the embodiments described above, an indicator such as a display or the like may be arranged on the upper surface 500 in addition to or as an alternative to the second aperture 520.

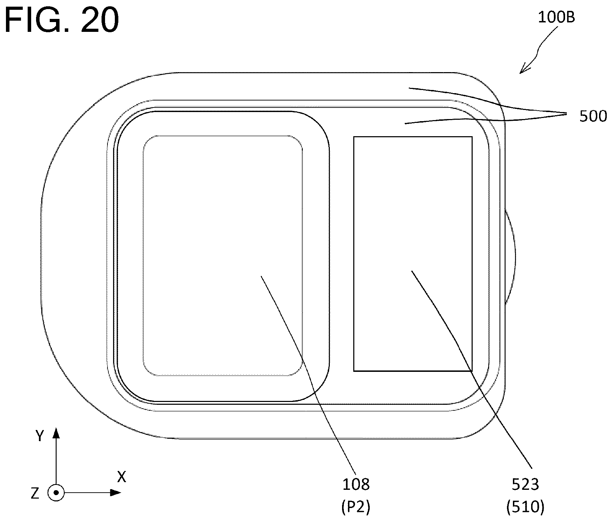

FIG. 20 is a plan view schematically illustrating a flavor inhaler 100B according to the present variant. The flavor inhaler 100B has a substantially similar configuration to that of the flavor inhaler 100 described above, but differs from the flavor inhaler 100 in that an indicator 523 is provided as the interface portion 510 instead of the second aperture 520.

The indicator 523 comprises a display device. In the illustrated example, the indicator 523 is a display such as a liquid crystal monitor. However, the indicator 523 is not limited thereto and can comprise any display device that can be arranged on the upper surface 500. For example, the indicator 523 can comprise a touch panel, a light emitting diode, or the like. If the indicator 523 is a light emitting diode, the status of the flavor inhaler 100B can be indicated by whether the light emitting diode is lit or not.

In the flavor inhaler 100B, when the sliding cover 108 is in the first position P1, at least a portion of the indicator 523 is covered by the sliding cover 108. As shown in FIG. 20, the flavor inhaler 100B is configured so that when the sliding cover 108 is in the second position P2, at least a portion of the first aperture 110 is covered and consumable material 120 cannot be inserted into the first aperture 110. The indicator 523 may be configured to be visible to the user when the sliding cover 108 is in the second position P2.

With such an arrangement, the indicator 523 can be less exposed when the consumable material 120 is inserted into the first aperture 110. Also, when the indicator 523 is exposed, insertion of the consumable material 120 into the first aperture 110 by the user can be made difficult. Therefore, the generation of foreign matter such as secondhand smoke or user-exhaled smoke and contact between the foreign matter and the indicator 523 can be reduced, and adverse effects of the foreign matter on the indicator 523 can be prevented.

Embodiments of the present invention were described above, but the present invention is not limited to those embodiments, and various modifications are possible within the scope of the technical concept disclosed in the claims, specification, and drawings. Moreover, any shape or material not directly stated in the specification or drawings is also within the scope of the technical concept of the invention of this application provided that it exhibits the action and effect of the invention of this application.

According to a first aspect of the present invention, a flavor inhaler comprises: a moveable member having a magnet and that can move along a first surface, and a board on which a Hall sensor is arranged, wherein the magnet is arranged in the moveable member so that a direction through its poles is along the first surface, and the board is arranged along a second surface that intersects with the direction.
According to a second aspect of the present invention, in the first aspect, the board extends substantially perpendicular to the first surface.
According to a third aspect of the present invention, in the first or second aspect, the Hall sensor is arranged to detect a magnetic field substantially parallel to the direction.
According to a fourth aspect of the present invention, in the third aspect, the direction of the magnetic field to be detected is configured to be substantially perpendicular to the board.
According to a fifth aspect of the present invention, in any one of the first to fourth aspects, the Hall sensor is configured to not perform bipolar detection.
According to a sixth aspect of the present invention, in any one of the first to fifth aspects, the direction and the second surface intersect between the poles of the magnet when the moveable member is in a position to be detected by the Hall sensor.
According to a seventh aspect of the present invention, any one of the first to sixth aspects further comprises a housing, wherein the moveable member is configured to slide along the housing.
According to an eighth aspect of the present invention, any one of the first to seventh aspects further comprises a control unit and a heating part for heating consumable material, wherein the moveable member can move between a first position that does not cover an aperture in which the consumable material is inserted and a second position that covers the aperture, and the control unit is configured to control the heating part on the basis of output from the Hall sensor.
According to a ninth aspect of the present invention, a flavor inhalation system comprises the flavor inhaler according to any one of the first to eighth aspects, and consumable material.

### REFERENCE SIGNS LIST

20: Power source unit
21: Power source
28: Bluetooth interface
30: Atomization unit
32: Heat insulating part
34: Insertion guide member
40: Heating part
50: Chamber
60, 1060: Magnet
70: Heat diffusion sleeve
80: Control unit
82, 1082: Board
100, 100A, 100B: Flavor inhaler
102, 1102: Housing
103: Inner housing
104: Upper housing
106: Lower housing
108, 1108: Sliding cover
110: First aperture
120: Consumable material
200: Bottom surface
201: Housing bottom surface
202: Adhesive surface
203: Housing inner surface
210: Covering member
211: Covering member outer surface
215: Peripheral portion
220, 220A: Vent opening
230: First recess
251: First region
252: Second region
300, 300A, 300B: Adhesive layer
500: Upper surface of the flavor inhaler
510: Interface portion
520: Second aperture
521: Connection portion
522: Input portion
523: Indicator
600, 1600: Hall element
900: External device
910: External terminal
AX: Central axis of the vent opening
D1: Depth of the first recess
P1: First position
P2: Second position
SP1: First region
S100: First surface
S200: Second surface
T1: Thickness of the covering member
W1: First width
W2: Second width

## Claims

1. A flavor inhaler, comprising: a moveable member having a magnet and that can move along a first surface; and
a board on which a Hall sensor is arranged, wherein
the magnet is arranged in the moveable member so that a direction through its two poles is along the first surface, and
the board is arranged along a second surface that intersects with the direction.

2. The flavor inhaler as claimed in claim 1, wherein the board extends substantially perpendicular to the first surface.

3. The flavor inhaler as claimed in claim 1 or claim 2, wherein the Hall sensor is arranged to detect a magnetic field substantially parallel to the direction.

4. The flavor inhaler as claimed in claim 3, wherein the direction of the magnetic field to be detected is configured to be substantially perpendicular to the board.

5. The flavor inhaler as claimed in any one of claims 1 to 4, wherein the Hall sensor is configured to not perform bipolar detection.

6. The flavor inhaler of any one of claims 1 to 5, wherein the direction and the second surface intersect between the two poles of the magnet when the moveable member is in a position detected by the Hall sensor.

7. The flavor inhaler as claimed in any one of claims 1 to 6, further comprising a housing, wherein the moveable member is configured to slide along the housing.

8. The flavor inhaler as claimed in any one of claims 1 to 7, further comprising: a control unit; and
a heating part for heating a consumable material,
wherein
the moveable member can move between a first position that does not cover an aperture in which the consumable material is inserted and a second position that covers the aperture; and
the control unit is configured to control the heating part based on output from the Hall sensor.

9. A flavor inhalation system comprising the flavor inhaler as claimed in any one of claims 1 to 8, and consumable material.
